## Europäisches Patentamt

(19) **European Patent Office**

**Office européen des brevets**

(11) Veröffentlichungsnummer: **0 126 788**
**B1**

(12) # EUROPÄISCHE PATENTSCHRIFT

(45) Veröffentlichungstag der Patentschrift:
**03.06.87**

(51) Int. Cl.⁴: **H 03 K 5/02**

(21) Anmeldenummer: **83105252.7**

(22) Anmeldetag: **27.05.83**

---

(54) **MOS-Bootstrap-Gegentaktstufe.**

---

(43) Veröffentlichungstag der Anmeldung:
**05.12.84 Patentblatt 84/49**

(45) Bekanntmachung des Hinweises auf die Patenterteilung:
**03.06.87 Patentblatt 87/23**

(84) Benannte Vertragsstaaten:
**DE FR NL**

(56) Entgegenhaltungen:
**EP - A - 0 045 133**
**DE - A - 2 356 974**
**DE - A - 2 920 966**

**Patent Abstracts of Japan, Band 5, Nr. 185, November 1981**
**IBM TECHNICAL DISCLOSURE BULLETIN, Band 23, Nr. 9, Februar 1981, L. ARZUBI et al.:"Bootstrap driver stage", Seiten 4185-4186**

(73) Patentinhaber: **Deutsche ITT Industries GmbH, Hans-Bunte-Strasse 19 Postfach 840, D-7800 Freiburg (DE)**

(84) Benannte Vertragsstaaten: **DE**

(73) Patentinhaber: **ITT INDUSTRIES INC., 320 Park Avenue, New York, NY 10022 (US)**

(84) Benannte Vertragsstaaten: **FR NL**

(72) Erfinder: **Backes, Reiner, Dipl.-Ing., Im Märzengraben 2, D-7800 Freiburg i.Br. (DE)**
Erfinder: **Schmidtpott, Friedrich, Dipl.-Ing., Am Büfing 6, D-7803 Gundelfingen (DE)**

(74) Vertreter: **Morstadt, Volker, Dipl.-Ing., c/o Deutsche ITT Industries GmbH Patent/Lizenzabteilung Postfach 840 Hans-Bunte-Strasse 19, D-7800 Freiburg/Brsg. (DE)**

---

## Beschreibung

Die Erfindung betrifft eine monolithisch in Isolierschicht-Feldeffekttransistor-Technik (MOS-Technik) integrierte digitale Bootstrap-Gegentaktstufe mit mindestens zwei mit ihren Drain-Source-Strecken zwischen der Versorgungsspannung und dem Schaltungsnullpunkt in Reihe geschalteten Enhancement-Endstufentransistoren und mit einem Bootstrap-Kondensator, der einerseits am Gate des mit der Versorgungsspannung verbundenen Endstufentransistors liegt, wodurch der Bootstrap-Knoten gebildet ist, und andererseits mit einem mit dem Potential des Ausgangs der Bootstrap-Gegentaktstufe mitlaufenden Schaltungspunkt verbunden ist. Die Bootstrap-Gegentaktstufe enthält ferner eine mit ihrem Taktsignaleingang direkt am Ausgang eines Taktoszillators liegende erste Ladungspumpschaltung, deren erste, die zur Polarität der Versorgungsspannung entgegengesetzte Polarität aufweisende Gleichspannungsklemme an der Versorgungsspannung liegt, sowie ferner Inverter und Kondensatoren.

Eine derartige Bootstrap-Gegentaktstufe ist aus der Offenlegungsschrift DE 23 59 646 bekannt. Diese Stufe ist hinsichtlich herstellungsbedingter, sich auf die jeweilige Gate-Spannung in Abhängigkeit von den Parametern der Gegentaktstufe auswirkenden Änderungen kompensiert, so dass das Einhalten des linearen Arbeitsbereichs gewährleistet ist. Auf verschiedenen Halbleiterplättchen jeweils zusammen mit ihren Lastschaltungen hergestellte Stufen haben nämlich prozessbedingte Parameterschwankungen untereinander, wenn eine extern erzeugte, für alle Gegentaktstufen gemeinsame Gate-Spannung zugeführt wird.

Demgegenüber liegt der in den Ansprüchen angegebenen Erfindung die Aufgabe zugrunde, bei der bekannten Schaltung zu erreichen, dass im Falle desjenigen Ausgangssignals-Pegels, der dem Potential der Versorgungsspannung entspricht oder zugeordnet ist, auch über längere Standzeiten dieses Pegels hin die entsprechende Spannung am Bootstrap-Knoten möglichst konstant bleibt, so dass der Ausgangssignal-Pegel ebenfalls konstant bleibt.

Ein Vorteil liegt unmittelbar in der Aufgabenlösung, da nur durch die Erfindung längere Signalstandzeiten am Ausgang mit konstantem Digitalpegel erreichbar sind.

Die Erfindung wird nun anhand der Figuren der Zeichnung näher erläutert.

Fig. 1 zeigt ein Prinzipschaltbild einer Bootstrap-Gegentaktstufe nach der Erfindung

Fig. 2 und 3 zeigen Schaltbilder unterschiedlicher Ausführungsbeispiele einer solchen Bootstrap-Gegentaktstufe.

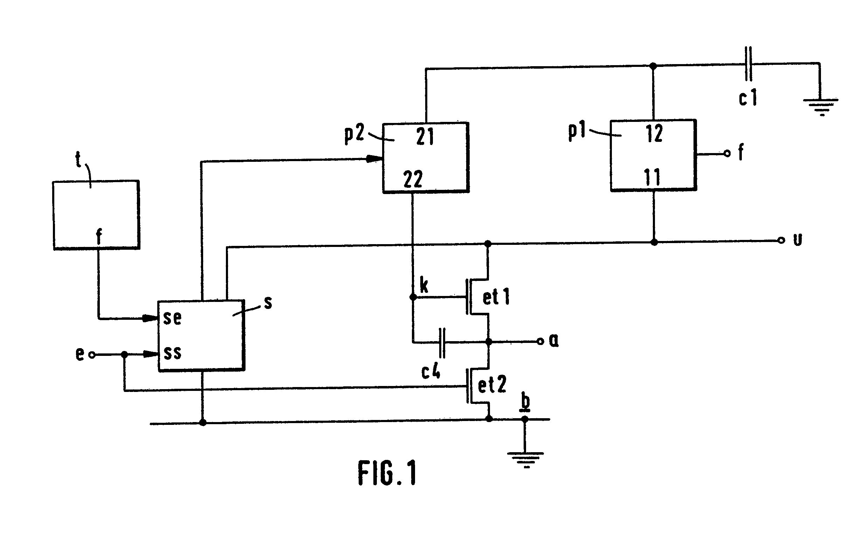

Das Prinzipschaltbild nach Fig. 1 zeigt die Bootstrap-Gegentaktstufe b mit den beiden Enhancement-Endstufentransistoren et1, et2, die mit ihren Source-Drain-Strecken zwischen der Versorgungsspannung u und dem Schaltungsnullpunkt in Reihe geschaltet sind, wobei deren Verbindungspunkt der Ausgang a der Bootstrap-Gegentaktstufe b ist. Der Bootstrap-Kondensator c4 liegt unter Bildung des Bootstrap-Knotens k am Gate des mit der Versorgungsspannung u verbundenen Endstufentransistors et1 und ist mit einem mit dem Potential des Ausgangs a mitlaufenden Schaltungspunkt verbunden. In Fig. 1 ist dieser Punkt der Ausgang a selbst. Die mit ihrem Taktsignaleingang am Ausgang f des Taktoszillators t liegende erste Ladungspumpschaltung p1 ist mit ihrer ersten Gleichspannungsklemme 11, die die zur Versorgungsspannung u entgegengesetzte Polarität hat, mit der Versorgungsspannung u verbunden.

Die zweite Gleichspannungsklemme 12 der ersten Ladungspumpschaltung p1 ist mit der ersten, die zur Polarität der Versorgungsspannung u entgegengesetzter Polarität aufweisenden Gleichspannungsklemme 21 der zweiten Ladungspumpschaltung p2 verbunden, deren zweite Gleichspannungsklemme 22 am Bootstrap-Knoten k liegt. Die zweite Gleichspannungsklemme 12 der ersten Ladungspumpschaltung p1 und die erste Gleichspannungsklemme 21 der zweiten Ladungspumpschaltung p2 liegen über dem ersten als Glättungskondensator dienenden Kondensator c1 am Schaltungsnullpunkt. Der Taktsignaleingang der zweiten Ladungspumpschaltung p2 liegt am Ausgang der Schaltstufe s, deren Signaleingang se am Ausgang f des Taktoszillators t und deren Steuereingang ss am Eingang e der Bootstrap-Gegentaktstufe angeschlossen ist. Die Schaltstufe s schaltet das Taktsignal durch, wenn das Eingangssignal der Bootstrap-Gegentaktstufe b den der Versorgungsspannung u zugeordneten Digitalpegel aufweist. Der Einfachheit halber ist im Prinzipschaltbild von Fig. 1 der Eingang e mit dem Gate des am Schaltungsnullpunkt liegenden Endstufentransistors et2 verbunden gezeigt.

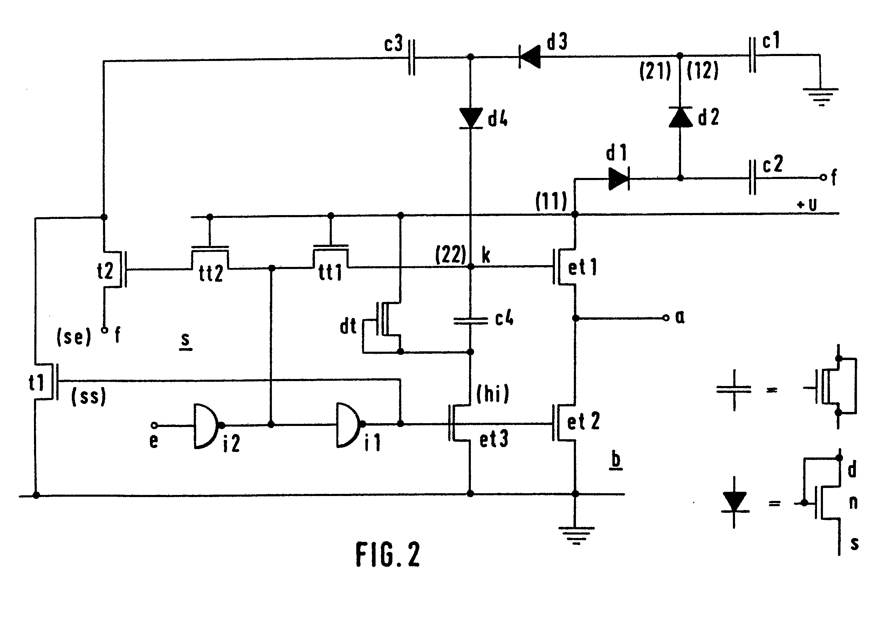

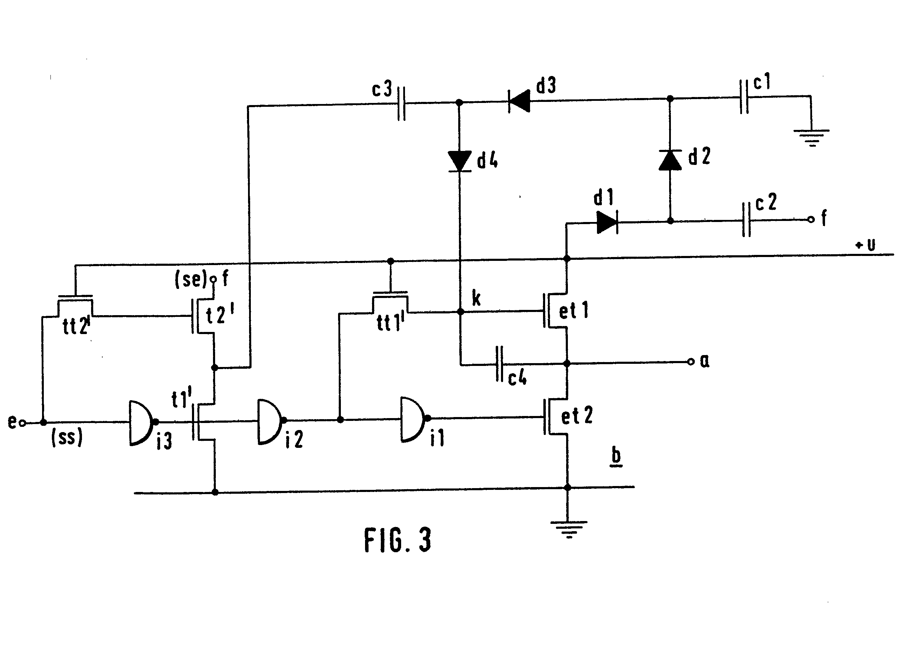

Die Fig. 2 und 3 zeigen Schaltbilder unterschiedlicher Ausführungsbeispiele einer Bootstrap-Gegentaktstufe nach der Erfindung. In beiden Beispielen ist der Aufbau der Ladungspumpschaltungen p1, p2 gleich; die erste bzw. zweite besteht aus der ersten und zweiten bzw. dritten und vierten MOS-Diode d1, d2; d3, d4 und dem zweiten bzw. dritten Kondensator c1; c3, wobei die MOS-Dioden d1, d2 bzw. d3, d4 zwischen den Gleichspannungsklemmen 11, 12 bzw. 21, 22 der Ladungspumpschaltungen p1, p2 gleichsinnig in Serie geschaltet sind.

In den Fig. 2 und 3 ist die Versorgungsspannung u positiv (+u) vorausgesetzt, und die Transistoren sind demzufolge n-Kanal-Transistoren. Dann liegt die erste MOS-Diode d1 mit ihrer Kathode, die zweite MOS-Diode d2 mit ihrer Anode über den zweiten Kondensator c2 am Taktausgang f des Taktoszillators t, die dritte MOS-Diode d3 mit ihrer Kathode und die vierte MOS-Diode d4 mit ihrer Anode über den dritten Kondensator c3 am Ausgang der Schaltstufe s. Die Anode der ersten MOS-Diode d1 ist mit der Versorgungsspannung +u und die Kathode der vierten MOS-Diode d4 mit dem Bootstrap-Knoten k verbunden.

In Fig. 2 liegt der bootstrapknoten-abgewandte Pol des Bootstrap-Kondensators c4 am Ausgang des Hilfsinverters hi. Dieser besteht aus dem Transistor et3, der mit seinem Gate am Gate des Endstufen-Transistors et2 und mit der Source am Schaltungsnullpunkt liegt, und aus dem Depletion-Transistor dt als Lastelement, dessen Drain mit der Versorgungsspannung +u verbunden ist. Den Endstufen-Transistoren et1, et2 ist die Treiberstufe aus dem Enhancement-Transfertransistor tt1 und den beiden Invertern i1, i2 zugeordnet, wobei das Gate des am Schaltungsnullpunkt liegenden Enstufentransistors et2 am Ausgang des ersten Inverters i1 liegt, dessen Eingang über die Source-Drain-Strecke des mit dem Gate an der Versorgungsspannung +u liegenden ersten Transfertransistors tt1 mit dem Bootstrap-Knoten k verbunden ist und an dessen Eingang der Eingang e der Bootstrap-Gegentaktstufe über den zweiten Inverter i2 liegt. Die Schaltstufe s besteht in Fig. 2 aus dem zwischen dem Schaltungsnullpunkt und ihrem Ausgang liegenden ersten Enhancement-Transistor t1, dessen Gate als Steuereingang ss mit dem Ausgang des ersten Inverters i1 verbunden ist, ferner aus dem zweiten Enhancement-Transistor t2, der mit seiner Source-Drain-Strecke zwischen dem Ausgang der Schaltstufe s und deren Signaleingang se liegt und dessen Gate über den mit seinem Gate an der Versorgungsspannung liegenden zweiten Enhancement-Transfertransistors tt2 am Ausgang des zweiten Inverters i2 und über die Source-Drain-Strecke des ersten Transfer-Transistors tt1 am Bootstrap-Knoten k liegt.

In Fig. 3 ist der bootstrapknoten-abgewandte Pol des Bootstrap-Kondensators c4 mit dem Ausgang a der Bootstrap-Gegentaktstufe direkt verbunden. Am Gate des End-Stufen-Transistors et2 liegt der Ausgang des ersten Inverters i1 der Treiberstufe, dessen Eingang am Ausgang des zweiten Inverters i2 liegt und über die Source-Drain-Strecke des an der Versorgungsspannung +u liegenden Transfertransistors tt1' mit dem Bootstrap-Knoten k verbunden ist. Der Eingang des zweiten Inverters i2 ist mit dem Ausgang des dritten Inverters i3 verbunden, dessen Eingang am Eingang e der Bootstrap-Gegentaktstufe b liegt.

Der Ausgang des dritten Inverters i3 liegt ferner am Gate des ersten Enhancement-Transistors t1' der Schaltstufe s, der mit seiner Source-Drain-Strecke zwischen dem Schaltungsnullpunkt und deren Ausgang liegt. Der zweite Enhancement-Transistor t2' liegt zwischen dem Ausgang und dem Signaleingang se der Schaltstufe s, wobei sein Gate über die Source-Drain-Strecke des mit seinem Gate an der Versorgungsspannung +u liegenden Transfertransistors tt2' mit dem Eingang e verbunden ist.

Die MOS-Dioden d1 . . . d4 sind Enhancement-Transistoren vom n-Kanal-Typ mit Gate-Drain-Verbindung als Diodenanode und die Kondensatoren c1, c2, c3 und der Bootstrap-Kondensator c4 Depletion-Transistoren vom gleichen Typ mit Gate-Source-Verbindung.

Zur Funktionserläuterung wird auf Fig. 3 Bezug genommen. Es wird vorausgesetzt, dass der H-Pegel der positivere der beiden Binärsignalpegel und demzufolge der L-Pegel der negativere ist. Die erste Ladungspumpschaltung p1 erzeugt, da ihr das Taktsignal des Taktoszillators t dauernd zugeführt ist, am Schaltungsnullpunkt-abgewandten Pol des ersten Kondensators c1 ein über dem Versorgungspotential +u liegendes Potential. Dieses höhere Potential wird von der zweiten Ladungspumpschaltung p2 bezüglich des Bootstrap-Knotens k in Abhängigkeit vom Digitalsignal am Eingang e nochmals erhöht. Es sei angenommen, dass am Eingang e ein H-Pegel liegt. Dann liegt auch am Gate des Transistors t2' ein H-Pegel, während am Gate des Transistors t1' ein L-Pegel liegt. Beide Bedingungen bewirken zusammen, dass das Taktsignal zur zweiten Ladungspumpschaltung p2 durchgeschaltet wird und diese somit dem Bootstrap-Knoten k eine entsprechend hohe Spannung zuführt. Der H-Pegel am Eingang e bewirkt über die Inverter i3, i2 und den Transfertransistor tt1' ebenfalls einen H-Pegel am Bootstrap-Knoten k. Da andererseits der H-Pegel am Eingang e über die Inverter i3, i2, i1 am Gate des Endstufentransistors et2 einen L-Pegel bedingt, ist dieser Transistor gesperrt, und somit liegt wie am Bootstrap-Knoten k ein H-Pegel am Ausgang a. Solange der H-Pegel am Eingang e anliegt, und somit auch am Ausgang der H-Pegel auftreten soll, ist dies unabhängig von den am Bootstrap-Knoten k wirksamen Leckströmen sichergestellt, da die beiden Ladungspumpschaltungen p1, p2 diese Leckströme kompensieren und somit am Bootstrap-Knoten k das für den H-Pegel am Ausgang a erforderliche hohe Potential dauernd aufrechterhalten.

Von einem Zustand mit von dem erwähnten H-Pegel am Eingang e vorausgehendem L-Pegel aus gesehen erfolgt die Sperrung des Endstufentransistors et2 um die Verzögerungszeit des Inverters i1 gegenüber der Erzeugung des H-Pegels am Bootstrap-Knoten k verzögert, so dass der Ausgang a vom L-Pegel am Eingang e bedingten L-Pegel erst auf den H-Pegel durchschaltet, wenn am Bootstrap-Knoten k schon der nunmehrige H-Pegel vorhanden ist und somit die Bootstrapwirkung des Bootstrap-Kondensators c4 voll sich auswirken kann.

Bei einem L-Pegel am Eingang e liegt am Gate des Transistors t1' ein H-Pegel, so dass dieser leitend ist, und am Gate des Transistors t2' ebenfalls ein L-Pegel, so dass dieser gesperrt ist. Somit liegt der Kondensator c3 praktisch auf dem Potential des Schaltungsnullpunkts, und es gelangen keine Taktsignale zur zweiten Ladungspumpschaltung p1. Am Bootstrap-Knoten k liegt ebenfalls ein L-Pegel, der jedoch vom Potential am Kondensator c1 überlagert ist, das über die Dioden d3, d4 dorthin gelangt ist. Der Endstufentransistor et2 ist wegen des an seinem Gate liegenden H-Pegels leitend gesteuert, so dass am Ausgang a ebenfalls ein L-Pegel auftritt.

Die Transfertransistoren tt1', tt2' bewirken während des Signalwechsels von einem L-Pegel zu einem H-Pegel jeweils einen Bootstrap-Effekt am mit ihnen verbundenen Gate des Transistors t2' bzw. des Endstufentransistors et1. Dadurch werden die Umschaltverhältnisse und somit die Flankensteilheit des Signalwechsels günstig beeinflusst.

**Patentansprüche**

1. Monolithisch in Isolierschicht-Feldeffekttransistor-Technik (MOS-Technik) integrierte digitale Bootstrap-Gegentaktstufe (b) mit mindestens zwei mit ihren Source-Drain-Strecken zwischen der Versorgungsspannung (u) und dem Schaltungsnullpunkt in Reihe geschalteten Enhancement-Endstufentransistoren (et1, et2) und mit einem Bootstrap-Kondensator (c4), der einerseits am Gate des mit der Versorgungsspannung (u) verbundenen Endstufentransistors (et1) liegt, wodurch der Bootstrap-Knoten gebildet ist, und andererseits mit einem mit dem Potential des Ausgangs (a) der Bootstrap-Gegentaktstufe (b) mitlaufenden Schaltungspunkt verbunden ist, ferner mit einer mit ihrem Taktsignaleingang direkt am Ausgang (f) eines Taktoszillators (t) liegenden ersten Ladungspumpschaltung (p1), deren erste, die zur Polarität der Versorgungsspannung (u) entgegengesetzte Polarität aufweisende Gleichspannungsklemme (11) an der Versorgungsspannung (u) liegt, und ferner mit Invertern (i1, i2, i3) und Kondensatoren (c1, c2, c3) gekennzeichnet durch folgende Merkmale:
– die zweite Gleichspannungsklemme (12) der ersten Ladungspumpschaltung (p1) ist mit der ersten, die zur Polarität der Versorgungsspannung (u) entgegengesetzte Polarität aufweisenden Gleichspannungsklemme (21) einer zweiten Ladungspumpschaltung (p2) verbunden,
– deren zweite Gleichspannungsklemme (22) liegt am Bootstrap-Knoten (k) und
– der Taktsignaleingang der zweiten Ladungspumpschaltung (p2) liegt über eine Schaltstufe (s) am Ausgang (f) des Taktoszillators (t), die das Taktsignal durchschaltet, wenn das Eingangssignal der Bootstrap-Gegentaktstufe (b) den der Versorgungsspannung (u) zugeordneten Digitalpegel aufweist.

2. Bootstrap-Gegentaktstufe nach Anspruch 1, dadurch gekennzeichnet, dass die zweite Gleichspannungsklemme (12) der ersten Ladungspumpschaltung (p1) und die erste Gleichspannungsklemme (21) der zweiten Ladungspumpschaltung (p2) über einen ersten Kondensator (c1) am Schaltungsnullpunkt liegen.

3. Bootstrap-Gegentaktstufe nach Anspruch 1 oder 2, dadurch gekennzeichnet, dass die beiden Ladungspumpschaltungen (p1, p2) jeweils aus einer ersten und zweiten bzw. dritten und vierten MOS-Diode (d1, d2; d3, d4) und einem zweiten bzw. dritten Kondensator (c2; c3) bestehen, wobei die jeweils beiden MOS-Dioden (d1, d2; d3, d4) zwischen den jeweils beiden Gleichspannungsklemmen (11, 12; 21, 22) gleichsinnig in Serie liegen.

4. Bootstrap-Gegentaktstufe nach Anspruch 3 mit n-Kanal-Transistoren, dadurch gekennzeichnet, dass die erste MOS-Diode (d1) mit ihrer Kathode bzw. die zweite MOS-Diode (d2) mit ihrer Anode über den zweiten Kondensator (c2) am Ausgang (f) des Taktoszillators (d) liegen, dass die dritte MOS-Diode (d3) mit ihrer Kathode bzw. die vierte MOS-Diode (d4) mit ihrer Anode über den dritten Kondensator (c3) am Ausgang der Schaltstufe (s) angeschlossen sind und dass die Anode der ersten MOS-Diode (d1) mit der Versorgungsspannung (u) sowie die Kathode der vierten MOS-Diode (d4) mit dem Bootstrap-Knoten (k) verbunden sind.

5. Bootstrap-Gegentaktstufe nach einem der Ansprüche 1 bis 4, dadurch gekennzeichnet, dass der bootstrap-knoten-abgewandte Pol des Bootstrap-Kondensators (c4) am Ausgang (a) der Bootstrap-Gegentaktstufe (b) oder am Ausgang eines Hilfsinverters liegt, dessen Eingang am Gate des mit dem Schaltungsnullpunkt verbundenen Endstufentransistors (et2) angeschlossen ist und dessen Lastelement ein Depletion-Transistor (dt) ist.

6. Bootstrap-Gegentakt-Endstufe nach Anspruch 5 mit n-Kanal-Transistoren, dadurch gekennzeichnet, dass der Depletion-Transistor (dt) mit Gate und Source am Bootstrap-Kondensator (d4) liegt.

7. Bootstrap-Gegentaktstufe nach Anspruch 4 oder 6, dadurch gekennzeichnet, dass die MOS-Dioden (d1 ... d4) Enhancement-Transistoren mit Gate-Drain-Verbindung als Diodenanode sind und dass der Bootstrap-Kondensator (c4) sowie die Kondensatoren (c1, c2, c3) Depletion-Transistoren mit Gate-Source-Verbindung sind.

8. Bootstrap-Gegentaktstufe nach einem der Ansprüche 1 bis 7, dadurch gekennzeichnet, dass den Endstufentransistoren (et1, et2) eine Treiberstufe derart zugeordnet ist, dass am Gate des am Schaltungsnullpunkt liegenden Endstufentransistors (et2) der Ausgang eines ersten Inverters (i1) liegt, dessen Eingang über die Source-Drain-Strecke eines mit dem Gate an der Versorgungsspannung (u) liegenden ersten Enhancement-Transfertransistors (tt1) mit dem Bootstrap-Knoten (k) verbunden ist, und dass der Eingang (e) der Bootstrap-Gegentaktstufe über einen zweiten Inverter (i2) am Eingang des ersten Inverters (e1) liegt.

9. Bootstrap-Gegentaktstufe nach Anspruch 8, dadurch gekennzeichnet, dass die Schaltstufe (s) aus einem zwischen dem Schaltungsnullpunkt und ihrem Ausgang liegenden ersten Enhancement-Transistor (t1) besteht, dessen Gate mit dem Ausgang des ersten Inverters (i1) verbunden ist, ferner aus einem zweiten Enhancement-Transistor (t2), der zwischen dem Ausgang der Schaltstufe (s) und deren Eingang liegt, und aus einem mit dem Gate an der Versorgungsspannung (u) liegenden zweiten Enhancement-Transfertransistor (tt2), der zwischen dem Gate des zweiten Enhancement-Transistors (t2) und dem Ausgang des zweiten Inverters (i2) liegt.

10. Bootstrap-Gegentaktstufe nach Anspruch 8, gekennzeichnet durch folgende Merkmale:

– die Schaltstufe (s) besteht aus einem zwischen dem Schaltungsnullpunkt und ihrem Ausgang liegenden ersten Enhancement-Transistor (t1'), dessen Gate am Ausgang eines dritten Inverters (i3) liegt, ferner aus einem zweiten Enhancement-Transistor (t2'), der zwischen dem Ausgang der Schaltstufe (s) und deren Eingang liegt, und aus einem mit dem Gate an der Versorgungsspannung (u) liegenden zweiten Enhancement-Transfertransistor (tt2'), der zwischen dem Gate des zweiten Enhancement-Transistors (t2') und dem Eingang (e) der Bootstrap-Gegentaktstufe (b) liegt, und

– der Eingang des zweiten Inverters (i2) liegt anstatt am Eingang (e) der Bootstrap-Gegentaktstufe (b) am Ausgang des dritten Inverters (i3).

**Revendications**

1. Etage push-pull à réaction (b) en circuit intégré numérique monolithique employant la technologie des transistors à effet de champ à grille isolée (technologie MOS) et comprenant au moins deux transistors d'étage de sortie à enrichissement (et1, et2) ayant leurs trajets drain-source connectés en série entre la tension d'alimentation (u) et la masse, un condensateur de réaction (c4) ayant une de ses bornes connectée à la grille du transistor d'étage de sortie (et1) couplé à la tension d'alimentation (u), formant ainsi le nœud de réaction, et ayant son autre borne connectée à un point suivant le potentiel de la sortie (a) de l'étage push-pull à réaction (b), un premier circuit de pompage de charge (p1) dont l'entrée d'horloge est connectée directement à la sortie (f) d'un oscillateur d'horloge (t) et dont la première borne de tension continue (11), de polarité opposée à celle de la tension d'alimentation (u), est connectée à la tension d'alimentation (u), ainsi que des inverseurs (i1, i2, i3) et des condensateurs (c1, c2, c3), caractérisé en ce que:

– la deuxième borne de tension continue (12) du premier circuit de pompage de charge (p1) est connectée à la première borne de tension continue (21) d'un deuxième circuit de pompage de charge (p2), la polarité de cette première borne de tension continue (21) étant opposée à celle de la tension d'alimentation (u),

– la deuxième borne de tension continue (22) du deuxième circuit de pompage de charge (p2) est connectée au nœud de réaction (k), et

– l'entrée d'horloge du deuxième circuit de pompage de charge (p2) est connectée à la sortie (f) de l'oscillateur d'horloge (t), par un étage de commutation (s) qui achemine le signal d'horloge si le signal d'entrée de l'étage push-pull à réaction (b) est au niveau logique attribué à la tension d'alimentation (u).

2. Etage push-pull à réaction selon la revendication 1, caractérisé en ce que la deuxième borne de tension continue (12) du premier circuit de pompage de charge (p1) et la première borne de tension continue (21) du deuxième circuit de pompage de charge (p2) sont connectées à la masse à travers un premier condensateur (c1).

3. Etage push-pull à réaction selon la revendication 1 ou 2, caractérisé en ce que le premier circuit de pompage de charge (p1) consiste en une première et une deuxième diode MOS (d1, d2) et un deuxième condensateur (c2), et en ce que le deuxième circuit de pompage de charge (p2) consiste en une troisième et une quatrième diode (d3, d4) et un troisième condensateur (c3), les deux diodes MOS (d1, d2; d3, d4) de chaque circuit de pompage (p1, p2) étant connectées en série dans le même sens entre les deux bornes de tension continue associées (11, 12; 21, 22).

4. Etage push-pull à réaction selon la revendication 3 et utilisant des transistors à canal N, caractérisé en ce que la cathode de la première diode MOS (d1) et l'anode de la seconde diode MOS (d2) sont connectées à la sortie (f) de l'oscillateur d'horloge (t) par l'intermédiaire du deuxième condensateur (c2), en ce que la cathode de la troisième diode MOS (d3) et l'anode de la quatrième diode MOS (d4) sont connectées à la sortie de l'étage de commutation (s) par l'intermédiaire du troisième condensateur (c3) et en ce que l'anode de la première diode MOS (d1) et la cathode de la quatrième diode MOS (d4) sont respectivement connectées à la tension d'alimentation (u) et au nœud de réaction (k).

5. Etage push-pull à réaction selon l'une quelconque des revendications 1 à 4, caractérisé en ce que la borne du condensateur de réaction (c4) qui n'est pas couplée au nœud de réaction est connectée à la sortie (a) de l'étage push-pull à réaction (b) ou à la sortie d'un inverseur auxiliaire dont l'entrée est connectée à la grille du transistor d'étage de sortie à la masse (et2) et dont la charge est un transistor à appauvrissement.

6. Etage push-pull à réaction selon la revendication 5 et employant des transistors à canal N, caractérisé en ce que le transistor à appauvrissement (dt) a sa grille et sa source connectées au condensateur de réaction (c4).

7. Etage push-pull à réaction selon la revendication 4 ou 6, caractérisé en ce que les diodes MOS (d1, d2, d3, d4) sont des transistors à enrichissement dont une connexion grille-drain forme l'anode et en ce que le condensateur de réaction (c4) et les autres condensateurs (c1, c2, c3) sont des transistors à appauvrissement dont la grille est connectée à la source.

8. Etage push-pull à réaction selon l'une quelconque des revendications 1 à 7, caractérisé en ce qu'un étage de commande est associé aux transistors d'étage de sortie (et1, et2), de façon telle que la grille du transistor de sortie à la masse (et2) est connectée à la sortie d'un premier inverseur (i1) dont l'entrée est connectée au nœud de réaction (k) par le trajet source-drain d'un premier transistor de transfert à enrichissement (tt1) dont la grille est connectée à la tension d'alimentation (u) et en ce que l'entrée (e) de l'étage push-pull est connectée à l'entrée du premier inverseur (i1) par un second inverseur (i2).

9. Etage push-pull à réaction selon la revendication 8, caractérisé en ce que l'étage de commutation (s) consiste en un premier transistor à enrichissement (t1) dont le trajet source-drain est situé entre la sortie de cet étage de commutation (s) et la masse et dont la grille est connectée à la sortie du premier inverseur (i1), un second transistor à enrichissement (t2) ayant son trajet source-drain connecté entre la sortie et l'entrée de l'étage de commutation (s), ainsi qu'un deuxième transistor de transfert à enrichissement (tt2) dont le trajet source-drain est situé entre la grille du deuxième transistor à enrichissement (t2) et la sortie du deuxième inverseur (i2) et dont la grille est connectée à la tension d'alimentation (u).

10. Etage push-pull à réaction selon la revendication 8, caractérisé en ce que:

– l'étage de commutation (s) consiste en un premier transistor à enrichissement (t1') dont le trajet drain-source est connecté entre la sortie de l'étage de commutation (s) et la masse, tandis que sa grille est connectée à la sortie d'un troisième inverseur (i3), un deuxième transistor à enrichissement (t2') dont le trajet source-drain est connecté entre la sortie et l'entrée de l'étage de commutation (s) et un deuxième transistor de transfert à enrichissement (tt2') dont le trajet source-drain est connecté entre l'entrée (e) de l'étage push-pull à réaction (b) et la grille du deuxième transistor à enrichissement (t2'), sa grille étant connectée à la tension d'alimentation (u) et

– l'entrée du deuxième inverseur (i2), au lieu d'être connectée à l'entrée (e) de l'étage push-pull à réaction (b), est connectée à la sortie du troisième inverseur (i3).

## Claims

1. Digital monolithic integrated bootstrap push-pull stage (b) using insulated-gate field-effect transistor technology (MOS technology) and comprising two enhancement-mode output-stage transistors (et1, et2) having their drain-source paths connected in series between the supply voltage (u) and ground, a bootstrap capacitor (c4) having one of its terminals connected to the gate of the output-stage transistor (et1) coupled to the supply voltage (u), whereby the bootstrap node is formed, and having its other terminal connected to a point following the potential of the output (a) of the bootstrap push-pull stage (b), a first charge pump circuit (p1) having its clock input connected directly to the output (f) of a clock oscillator (t) and having its first direct-voltage terminal (11), whose polarity is opposite to that of the supply voltage (u), connected to the supply voltage (u), and inverters (i1, i2, i3) and capacitors (c1, c2, c3), characterized by the following features:

– The second direct-voltage terminal (12) of the first charge pump circuit (p1) is connected to the first direct-voltage terminal (21) of a second charge pump circuit (p2), the polarity of said first direct-voltage terminal (21) being opposite to that of the supply voltage (u);

– the second direct-voltage terminal (22) of the second charge pump circuit (p2) is connected to the bootstrap node (k), and

– the clock input of the second charge pump circuit (p2) is connected to the output (f) of the clock oscillator (t) via a switching stage (s) which passes on the clock signal if the input signal to the bootstrap push-pull stage (b) is at the logic level assigned to the supply voltage (u).

2. A bootstrap push-pull stage as claimed in claim 1, characterized in that the second direct-voltage terminal (12) of the first pump circuit (p1) and the first direct-voltage terminal (21) of the second charge pump circuit (p2) are grounded through a first capacitor (c1).

3. A bootstrap push-pull stage as claimed in claim 1 or 2, characterized in that the first pump circuit (p1) consists of a first and a second MOS diode (d1, d2) and a second capacitor (c2), and that the second pump circuit (p2) consists of a third and a fourth MOS diode (d3, d4) and a third capacitor (c3), with the two MOS diodes (d1, d2; d3, d4) of each pump circuit (p1, p2) connected in series in the same direction between the two associated direct-voltage terminals (11, 12; 21, 22).

4. A bootstrap push-pull stage as claimed in claim 3 using n-channel transistors, characterized in that the cathode of the first MOS diode (d1) and the anode of the second MOS diode (d2) are connected to the output (f) of the clock oscillator (t) through the second capacitor (c2), that the cathode of the third MOS diode (d3) and the anode of the fourth MOS diode (d4) are connected to the output of the switching stage (s) through the third capacitor (c3), and that the anode of the first MOS diode (d1) and the cathode of the fourth MOS diode (d4) are connected to the supply voltage (u) and the bootstrap node (k), respectively.

5. A bootstrap push-pull stage as claimed in any one of claims 1 to 4, characterized in that that terminal of the bootstrap capacitor (c4) which is not coupled to the bootstrap node is connected to the output (a) of the bootstrap push-pull stage (b) or to the output of an auxiliary inverter whose input is connected to the gate of the grounded output-stage transistor (et2), and whose load device is a depletion-mode transistor (dt).

6. A bootstrap push-pull stage as claimed in claim 5 using n-channel transistors, characterized in that the depletion-mode transistor (dt) has its gate and source connected to the bootstrap capacitor (c4).

7. A bootstrap push-pull stage as claimed in claim 4 or 6, characterized in that the MOS diodes (d1 ... d4) are enhancement-mode transistors with a gate-drain connection forming the anode, and that the bootstrap capacitor (c4) and the capacitors (c1, c2, c3) are depletion-mode transistors with a gate-source connection.

8. A bootstrap push-pull stage as claimed in any one of claims 1 to 7, characterized in that a driver stage is associated with the output-stage transistors (et1, et2) in such a way that the gate of the grounded output-stage transistor (et2) is connected to the output of a first inverter (i1) having its input connected to the bootstrap node (k) via the source-drain path of a first enhancement-mode transfer transistor (tt1) having its gate connected to the supply voltage (u), and that the input (e) of the bootstrap push-pull stage is connected to the input of the first inverter (i1) via a second inverter (i2).

9. A bootstrap push-pull stage as claimed in claim 8, characterized in that the switching stage (s) consists of a first enhancement-mode transistor (t1) whose source-drain path is located between the output of said switching stage (s) and ground and whose gate is connected to the output of the first inverter (i1), a second enhancement-mode transistor (t2) having its source-drain path connected between the output and the input of the switching stage (s), and a second enhancement-mode transfer transistor (tt2) whose source-drain path is located between the gate of the second enhancement-mode transistor (t2) and the output of the second inverter (i2), and whose gate is connected to the supply voltage (u).

10. A bootstrap push-pull stage as claimed in claim 8, characterized by the following features:
- The switching stage (s) consists of a first enhancement-mode transistor (t1') having its drain-source path connected between the output of the switching stage (s) and ground and having its gate connected to the output of a third inverter (i3), a second enhancement-mode transistor (t2') having its source-drain path connected between the output and the input of the switching stage (s), and a second enhancement-mode transfer transistor (tt2') having its source-drain path connected between the input (e) of the bootstrap push-pull stage (b) and the gate of the second enhancement-mode transistor (t2') and having its gate connected to the supply voltage (u), and
- the input of the second inverter (i2), instead of being connected to the input (e) of the bootstrap push-pull stage (b), is connected to the output of the third inverter (i3).

1/3

FIG.1

FIG.2

0 126 788

FIG. 3

0 126 788